# EUROPEAN PATENT SPECIFICATION

(11) **EP 1 492 168 B1**
(45) Date of publication and mention of the grant of the patent: **18.07.2018**
(21) Application number: 03708524.8
(22) Date of filing: 10.03.2003
(51) Int. Cl.: H01L 27/146, G01T 1/20

(54) **SENSOR**
SENSOR
DETECTEUR

(30) Priority: 08.03.2002 JP 2002064227
(43) Date of publication of application: 29.12.2004
(73) Proprietor: HAMAMATSU PHOTONICS K.K., Hamamatsu-shi, Shizuoka-ken 435-8558 (JP)
(72) Inventor: SHIBAYAMA, Katsumi, c/o Hamamatsu Photonics K.K., Hamamatsu-shi, Shizuoka 435-8558 (JP)
(74) Representative: Boult Wade Tennant
(86) International application number: PCT/JP2003/002803
(87) International publication number: WO 2003/077318

(56) References cited:
- EP-A1- 0 926 931
- EP-A1- 1 589 581
- WO-A-03/077318
- WO-A2-00/05748
- JP-A- 4 035 474
- JP-A- 5 268 535
- JP-A- 8 330 469
- JP-A- 2001 339 057
- US-A- 5 043 582
- US-A- 5 245 191
- US-A- 5 315 147
- US-A- 5 464 984
- US-A- 5 477 933
- US-A- 6 050 832
- US-A- 6 137 164
- US-B1- 6 194 726

## Description

### Technical Field

The present invention relates to a detector for use in an X-ray imaging device, or the like.

### Background Art

A conventional detector which can be used in an X-ray imaging device is described in the following references:
(1) Japanese Patent Laid-open No. (Hei)4-254377
   This reference discloses an installation structure for an optical detector. In this installation structure, a back-illuminated photodiode array is connected via a bump to a signal processing section. Since the optical signal sampling electrodes are provided on the back surface of the photodetector substrate, it is possible to use virtually all of the surface of the substrate as a light incident surface, and hence the aperture ratio is improved greatly compared to a conventional device. Moreover, the photoreceptor section uses a PIN type photodiode, the light incident via the I layer is absorbed with high efficiency, the junction capacitance can be reduced due to presence of the I layer, the depletion layer traveling time of the carrier can be shortened by applying a high voltage, and the mechanical strength can be increased. The signal charge extracted from each pixel is input to a signal processing circuit substrate.
(2) Japanese Patent Laid-open No. (Hei)9-288184
   This reference discloses a radiation detecting device which adopts a layered structure for the light detecting section, wiring substrate, driving integrated circuit and signal processing integrated circuit, in order to protect the integrated circuits from radiation.
(3) Japanese Patent Laid-open No. (Hei)7-333348
   This reference discloses an X-ray CT (Computer Tomography) device. Since the X-ray CT device emits the output of a photodiode array via a bump formed on the opposite side to the side on which the X-rays are incident, it permits the respective radiation detector elements to be arranged in a highly dense configuration in the two-dimensional direction, without reducing the detection sensitivity of the radiation detector elements, and therefore allows a broad range of X-ray data to be obtained in a single X-ray irradiation operation.
(4) Japanese Patent Laid-open No. (Hei)5-90554
   This reference discloses a detector wherein the output of an HgCdTe photodiode array is connected via a bump in order to be read by an Si-CCD. The driving voltage from the DC power source driving the photodiode array is applied via the wiring on the Si-CCD. In other words, the surface on the Si-CCD side is formed with a dual wiring structure, a first wiring system being used to supply the output of the respective photodiodes to respective pixels (read-out regions) of the CCD via a bump, and the second wiring system forming wiring for supplying a voltage from the DC power source to a photodiode array.

US 5,464,984 describes an X-Ray detector formed from a hybrid detector assembly consisting of a scintillator, a sensor tile having bond pads, an array of epoxy conductors in a pattern to match the bond pads on the sensor tile and a ceramic substrate containing an array of conductive wires which are aligned with the epoxy conductors and bond pads.

US 6194726 B1 and WO0005748 A2 describe hybrid semiconductor detectors with tiles of semiconductor chips each connected with smaller circuit substrates.

### Disclosure of the Invention

However, in the case of any of these detectors, the supporting substrate is larger than the semiconductor chip, and therefore it is not possible to dispose a plurality of detectors in a mutually adjacent configuration, such that there is no gap therebetween. Of course, if the supporting substrate is made smaller and the circuits are positioned to the side, then it is possible to dispose the detectors in a two row and two column matrix, but in the case of a three row and three column matrix, for example, there is no space to extract the output from the centrally positioned detector.

The present invention was devised with the foregoing problems in view, an object thereof being to provide a detector which allows respective semiconductor chips to be placed in extremely proximate configuration or mutually contacting configuration, when a plurality of detectors are arranged together.

In order to achieve the aforementioned object, the detector relating to the present invention is a detector as described in claim 1.

According to this detector, since the interval between the input terminals of the circuit substrate is set to a smaller dimension than the interval between the output terminals, and a signal reading circuit is formed on the circuit substrate in a region outside the region where the input terminals are formed, it is possible to reduce the dimensions of the circuit substrate below those of the semiconductor chip, and consequently, when a plurality of detectors are arranged together, it is possible to position the semiconductor chips in a mutually proximate or mutually contacting configuration. Therefore, the dead area become small because the gap between pixel (photodiode)groups are extremely small, one of the pixel groups being positioned at outermost periphery of one semiconductor chip and the other of the pixel groups being positioned at outermost periphery of the other semiconductor chip. So, it is possible to pickup large images.

Moreover, the connecting means may also provide a connection of the outputs of the circuit substrate to external leads, and a connection from external leads to the inputs of the circuit substrate, in which case the circuit structure can be simplified.

Furthermore, the connecting means may also constitute a supporting substrate for the semiconductor chip. In other words, by means of the connecting means supporting the semiconductor chip, it is possible to increase the mechanical strength of the detector.

Furthermore, the supporting substrate may have a depression for accommodating the circuit substrate, in which case the circuit substrate is protected by the supporting substrate.

Moreover, the connecting means may be formed by burying metal wiring inside a ceramic base member, the metal wiring being electrically connected to the output terminals of the semiconductor chip and the input terminals of the circuit substrate. Since ceramic has excellent insulating properties, it is possible to isolate the metal wires electrically by means of the ceramic base member, and hence a multiple-layer wiring structure can be formed inside the base member.

Furthermore, the detector according to the present invention may also comprise a scintillator formed on the light incident side of the semiconductor chip. A scintillator generates fluorescence in response to the incidence of radiation, such as X rays, or the like. This fluorescence can be detected by the semiconductor chip.

Moreover, the connecting means may also be constituted by a multiple-layer wiring substrate, the output terminals of the semiconductor chip and one surface of the multiple-layer wiring substrate being connected by means of bumps, and the other surface of the multiple-layer wiring substrate and the input terminals of the circuit substrate being connected by means of bumps. In this case, since it is possible to form the semiconductor chip, multiple-layer wiring substrate, and circuit substrate independently, manufacturing yield can be improved, in addition to which, the overall thickness of the device can be reduced by using a relatively thin multiple-layer wiring substrate.

Furthermore, the connecting means may be constituted by thin film multiple-layer wiring formed on one surface of the semiconductor chip, the terminals facing to the circuit substrate and provided on the thin film multiple-layer wiring and the input terminals of the circuit substrate being connected by means of bumps. The thin film multiple-layer wiring has a very small thickness, the overall thickness can be reduced significantly.

Moreover, the detector according to the present invention is a detector comprising a semiconductor chip on which a plurality of photodetector elements are formed, a circuit substrate to which output signal from the semiconductor chip are input, and a supporting substrate for supporting the semiconductor chip and the circuit substrate, wherein the dimensions of the supporting substrate in the directions perpendicular to the thickness direction thereof are equal to or less than the dimensions of the semiconductor chip in the directions perpendicular to the thickness direction thereof.

In other words, in this detector, since the dimension of the supporting substrate is equal to or smaller than the dimension of the semiconductor chip, this dimension being along the perpendicular direction to the thickness of the supporting substrate, it is possible to arrange a plurality of semiconductor chips in an extremely proximate or mutually contacting configuration. The circuit substrate is a substrate on which a signal reading circuit is formed.

Moreover, if this supporting substrate constitutes a portion of a package for accommodating the circuit substrate, then the circuit substrate is protected by the package.

Furthermore, in this case, the dimensions of the circuit substrate in the directions perpendicular to the thickness direction thereof are less than the dimensions of the semiconductor chip in the directions perpendicular to the thickness direction thereof.

In other words, the detector according to the present invention comprises a semiconductor chip formed with a plurality of photodetector elements, and a circuit substrate to which all the output signals of the semiconductor chip are input, wherein the dimensions of the circuit substrate in the directions perpendicular to the thickness direction thereof are less than the dimensions of the semiconductor chip in the directions perpendicular to the thickness direction thereof. Since the circuit substrate to which all the output signals from the semiconductor chip is small, it is possible to arrange the plurality of semiconductor chips in an extremely proximate or mutually contacting configuration.

### Brief Description of the Drawings

Fig. 1 is a block diagram in side view showing the composition of a detector D relating to an embodiment of the invention;
Fig. 2 is an illustrative diagram showing the plan view of a circuit substrate;
Fig. 3 is a plan view of an imaging device comprising a plurality of detectors;
Fig. 4 is a side view of an imaging device;
Fig. 5 is a vertical sectional view of a detector D being a preferred example of the detector D shown in Fig. 1;
Fig. 6 is a sectional view of a detector D in the vicinity of the PN junction;
Fig. 7 is a vertical sectional view of a detector D being a further preferred example of the detector D shown in Fig. 1;
Fig. 8 is a vertical sectional view of a detector D being yet a further preferred example of the detector D shown in Fig. 1;
Fig. 9 is a diagram in side view showing the composition of a detector D having a thin semiconductor chip;
Fig. 10 is a diagram in side view showing the composition of a detector D comprising a semiconductor chip having an undulating section on the light incident side thereof;
Fig. 11 is a diagram in side view showing the composition of a detector D comprising a semiconductor chip having an undulating section on the circuit substrate side thereof;
Fig. 12 is a diagram in side view showing the composition of a detector D comprising a semiconductor chip having undulating sections on the light incident side and the circuit substrate side thereof; and
Fig. 13 is a vertical sectional view of a detector D being a preferred example of the detector D shown in Fig. 1.

### Best Modes for Carrying Out the Invention

Below, a detector relating to the present embodiment is described. The same reference numerals are used for the same elements and duplicated descriptions are omitted here.

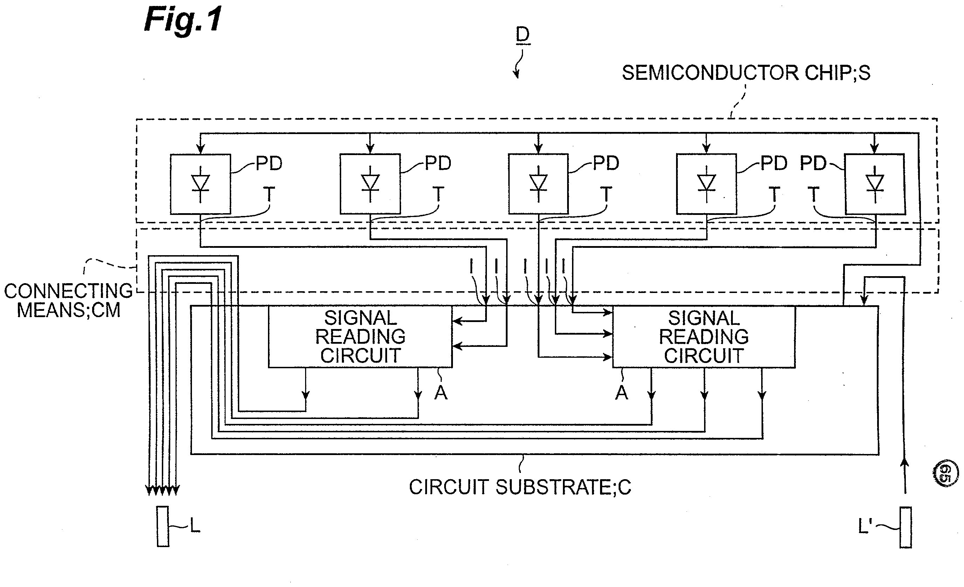

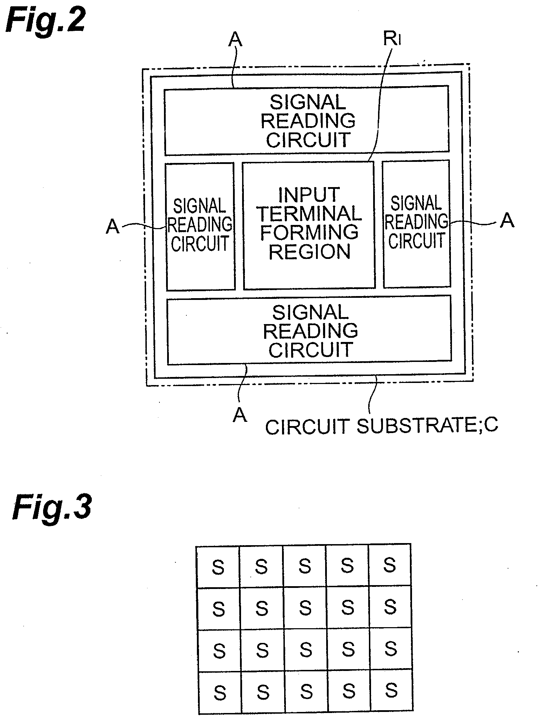

Fig. 1 is a block diagram in side view showing the composition of a detector D relating to this embodiment, and Fig. 2 is an illustrative diagram showing the plan view of the circuit substrate. The detector D comprises a semiconductor chip S, circuit substrate C, and connecting means CM for connecting same. A plurality of photodetector elements (photodiodes) PD are formed in a one-dimensional or two-dimensional configuration on the semiconductor chip S, and a plurality of output terminals T of the photodetector elements PD are disposed on the surface thereof. These output terminals T directly oppose the circuit substrate C, but the structure varies depending on the type of photodetector element.

If the semiconductor chip S is a back-side illuminated photodiode, since the output terminals T are essentially located on the circuit substrate C side of the semiconductor chip S, they should be connected directly to the circuit substrate C. If the semiconductor chip S is a front-side illuminated, then the output terminals T are essentially located on the opposite side of the semiconductor chip S to the circuit substrate C, and therefore through holes or the like must be formed through the semiconductor chip S to extend the output terminals T to the back surface side and connect same to the circuit substrate C.

The circuit substrate C comprises a plurality of input terminals I to which signals from the output terminals T of the semiconductor chip S are input.

The connecting means CM electrically connects the respective output terminals T to the respective input terminals I.

Here, the interval between the input terminals I is set to a narrower dimension than the interval between the output terminals T. Consequently, the circuit substrate C can be provided with a signal reading circuit A for reading out the -signals from the input terminal I, in the region outside the region R_{I} of the input terminals I.

In this detector, since the region R_{I} of the circuit substrate C where the input terminal I is formed is smaller than the region of the semiconductor chip S where the output terminal T is formed, it is possible to form a signal reading circuit A in the region outside the input terminal forming region R_{I} in the circuit substrate C, then the dimensions of the circuit substrate C can be reduced below those of the semiconductor chip S, and consequently, if a plurality of photodetectors D are arrayed together, respective semiconductor chips S can be arranged in a mutually proximate or contacting configuration.

Therefore, the dead area become small because the gap between pixel groups are extremely small, where the pixel groups are one of the pixel group being positioned at outermost periphery of one semiconductor chip and the other pixel group being positioned at outermost periphery of the other semiconductor chip. So, it is possible to pickup large images.

The connecting means CM also provides a connection from the electrical signal output of the circuit substrate C to an external lead L, or a connection from an external lead L' to an electrical signal input of the circuit substrate C. In this case, it is not necessary to use an additional electric wire, apart from the connecting means CM, and therefore the circuit composition can be simplified.

A portion of the power supply voltage applied to the circuit substrate C via the external lead L' is transmitted via the connecting means CM to the semiconductor chip S, and is used to drive the photodetector elements PD, while the other portion thereof is used to drive the signal reading circuit A. On the other hand, the output signals from the respective photodetector elements PD are input via the output terminals T, and input terminals I to the signal reading circuit A and processed by the signal reading circuit A, and led out of the device by the external lead L. The signal reading circuit A according to this example is a single or multiplex circuit consisting of a scanning circuit such as shift resistors 'switches' or the like, and a charge amplifier or integrating circuit, or the like. Furthermore, according to requirements, a correlated double sampling (CDS) circuit, or A/D converter, may be provided. The signal reading can be either serial or parallel.

According to requirements, the detector D according to this example may comprise a scintillator provided on the surface of the semiconductor chip S, and in this case, it is possible to apply the detector in an X-ray imaging apparatus, such as an X-ray CT device. An X-ray CT device captures an image of the X rays from an X ray source which are transmitted by a body under observation, and uses a plurality of detectors D in an aligned configuration.

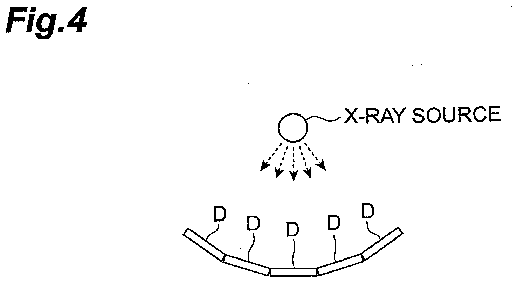

Fig. 3 is a plan view of an imaging device when viewed from the light illuminated surface, the imaging device consisting of a plurality of detectors, and Fig. 4 is a side view of an imaging device. Square shaped semiconductor chips S are arranged in mutually proximate configuration without any intervals therebetween, on the front surface. In this example, an imaging device comprising a 4 row by 5 column group of detectors is illustrated. Here, the detectors D forming the imaging device are aligned in parallel with one axial direction, in such a manner that they are spaced at equal distances from the X ray source. This does not exclude the possibility of disposing detectors D in alignment with two orthogonal axes, in such a manner that they are spaced at equal distances from the X ray source. Moreover, the detectors D may also be disposed in such a manner that the imaging surface of the imaging element is flat.

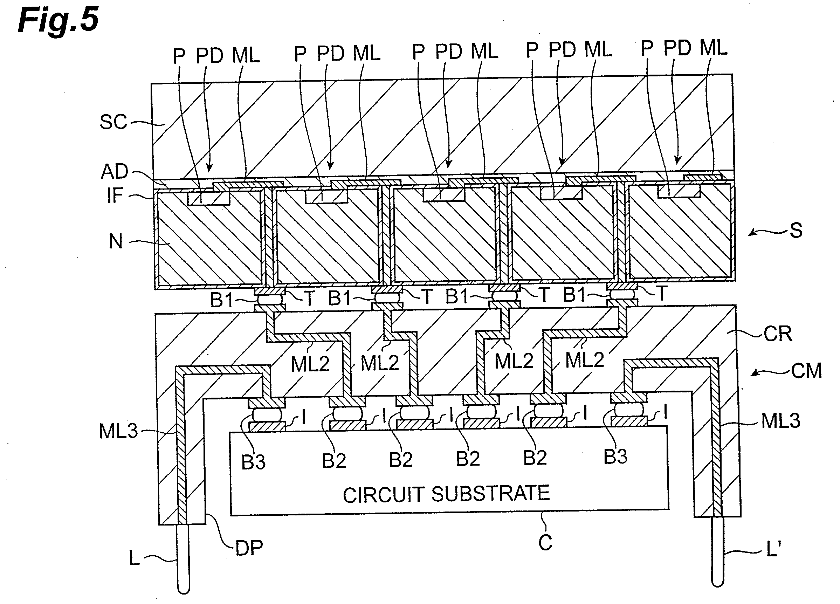

Fig. 5 is a cross-sectional view of a detector D showing a preferred example of the detector D illustrated in Fig. 1. The semiconductor chip S comprises an array of photodetector elements having a front side illuminated surface (photodiode array), and each photodetector element has a PN junction.

The P type semiconductor (P) creating the anode forming one part of the PN junctions is disposed on the front side of the semiconductor chip, and is connected to an output terminal T provided on the back surface, by means of a metal wire ML buried in a through hole which passes through the thickness of the semiconductor chip. The material of metal wire ML is not limited to a metal. The material of the metal wire ML can be made of an impurity-doped low resistance semiconductor. This P type semiconductor (P) has a high concentration of P type impurity. Moreover, the photodetector element PD disposed on the right-hand end of the diagram is connected to the output terminal of the back surface of the chip via a metal wire ML passing in the thickness direction of the paper in the diagram, similarly to the other photodetector elements PD, but it is not represented in the drawing.

Moreover, it may diffuse the high concentration N-type impurities (isolation area) into the regions between the respective detection elements PD of the semiconductor chip S in order to isolate the pixels, the isolation area being not illustrated in the figure.

Though a cathode electrode isn't illustrated in the figure, such a cathode electrode can be formed by forming the isolation area or an N-type high concentration impurities area in the suitable position of the surface. It is possible to provide this cathode electrode on the circuit substrate side of the chip via a through hole as the anode electrode is provided. Or, it is possible that a cathode electrode is made by forming a structure made by diffusing N-type high concentration impurities into a suitable place of the semiconductor chip S, the place being facing to the circuit substrate. In this case, the cathode electrode can be derived from the circuit substrate side of the chip. At any rate, the cathode electrode is connected to the connection means CM through the bump, too.

In this example, the connecting means CM constitutes a supporting substrate of the semiconductor chip S and serves to increase the mechanical strength of the detector D. This supporting substrate CM comprises a depression DP which accommodates the circuit substrate C, and the circuit substrate C is protected by means of the supporting substrate CM in the package. In the supporting substrate CM, metal wires ML2 are buried inside a ceramic substrate CR, and metal wires ML2 are connected to the output terminals T and the terminal bumped with the input terminals I. Ceramic has excellent insulating properties, and hence the metal wires ML2 are isolated from each other by the ceramic substrate CR and a multi-layer wiring structure is formed inside the substrate.

The output terminals T of the semiconductor chip S and one surface of the supporting substrate CM are connected via bumps B1, while the other surface of the supporting substrate CM and the input terminals I of the circuit substrate C are connected via bumps B2.

Furthermore, metal wires ML3 buried inside the supporting substrate CM are connected via bumps B3 to the external leads L, L' and the circuit substrate C. The outside lead L, L' can be the products which consist of the wiring films (a flexible circuit substrate), TAB tapes or the like, the base material of the wiring film being made of a metal pin, a metal ball or an organic film such as polyimide. When the above wiring film is used, an electrical connector can be provided on an opposite side of the wiring film from the connecting means CM.

This detector D comprises a semiconductor chip S on which a plurality of photodetector elements PD are formed, a circuit substrate C to which the output signal from the semiconductor chip S is input, and a supporting substrate CM (hereinafter, SB) which supports the semiconductor chip S and the circuit substrate C, the dimensions of the supporting substrate in the directions (X, Y directions) perpendicular to the thickness direction (Z direction) thereof being equal to or less than the dimensions of the semiconductor chip in the directions (X, Y directions) perpendicular to the thickness direction (Z direction) thereof. This means that the supporting substrate is of smaller dimensions in both X and Y directions.

In this detector, since the dimension of the supporting substrate CM is equal to or smaller than the dimension of the semiconductor chip S, it is possible to align a plurality of semiconductor chips S in a very proximate configuration or a contacting configuration. The circuit substrate C is a substrate on which a circuit is formed. Since the supporting substrate CM constitutes a portion of the package accommodating the circuit substrate C, the circuit substrate C is protected by the package, but in this case, the dimensions of the circuit substrate C in the directions (X, Y directions) perpendicular to the thickness direction (Z direction) thereof are less than the dimensions of the semiconductor chip S in the directions (X, Y directions) perpendicular to the thickness direction (Z direction) thereof. The circuit substrate C is smaller in both the X direction and the Y direction.

In other words, this detector comprises a semiconductor chip S on which a plurality of photodetector elements PD are formed, and a circuit substrate C to which all the output signals of the semiconductor chip S are input, the dimensions of the circuit substrate C in the directions orthogonal to the thickness direction being less than the dimensions of the semiconductor chip in the directions orthogonal to the thickness direction. Since the circuit substrate C to which all of the output signals of the semiconductor chip S are input is small, it is possible to align a plurality of semiconductor chips S in a very proximate or mutually contacting configuration.

Moreover, a composition is adopted wherein an insulating film IF is formed on the side wall of the through hole and the front surface and back surface of the semiconductor chip S, and the metal wires ML are not connected electrically to any elements other than the P type semiconductors (P). Note that the insulating film IF consists of a single film or a film stack. A scintillator SC is provided on the surface of the semiconductor chip S, via an adhesive AD. The scintillator SC is coupled optically to the light receiving surface of the semiconductor chip S. When radiation, such as X rays, is incident on the scintillator SC, fluorescence is generated. This fluorescence can be detected by the plurality of photodetector elements PD provided on the semiconductor chip S. This fluorescence is similar to an X ray image, and therefore X ray images can be captured by means of this imaging device. The material of the scintillator SC in the present example is CWO : CdWO₄ (cadmium tungstate) or Gd₂O₂S, but other materials may also be used.

An activator element (Eu) may be added to the Gd₂O₂S. By adjusting the concentration of the activator element (Eu) added to the crystals (Gd₂O₂S) to an optimum value, it is possible to generate fluorescence in the three primary colors, red, green and blue, in response to the X rays, and hence the dynamic range can be varied. The scintillator is applicable to the semiconductor chip such as CCD image pickup device using photodetector elements as the constituent pixels. Tb, or the like, may also be used as the additive. The scintillator SC may cover a plurality of photodetector elements PD and may also cover a plurality of semiconductor chips S.

Here, a short description of the function of the photodetector element PD forming the photodiode is given below.

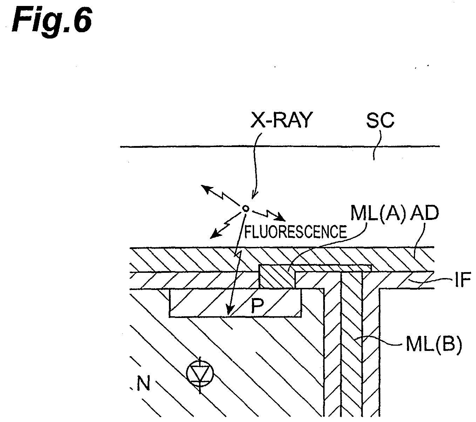

Fig. 6 is a sectional view of a photodetector element D in the vicinity of the PN junction. When X rays are incident on the scintillator SC, fluorescence is generated by the scintillator SC, and when this fluorescence is incident on the PN junction, carriers are generated inside the semiconductor depletion layer and one of the carriers is extracted out of the device via the metal wires ML. The metal wires ML comprise a surface electrode section ML(A) which contacts with the P type semiconductor (P) and a through electrode section ML(B) which passes through the inside of a through hole.

The surface electrode section ML(A) is made from Al, and the through electrode section ML(B) is made from polycrystalline Si. After forming through holes in the semiconductor chip S made from Si, it is possible to form a thermal oxide film (SiO₂) on the exposed face of the semiconductor chip S and the through hole. The formed oxide film can be processed using a suitable photolithography technique, and it is possible to form insulating film by a CVD (chemical vapour deposition) or sputtering method, as required.

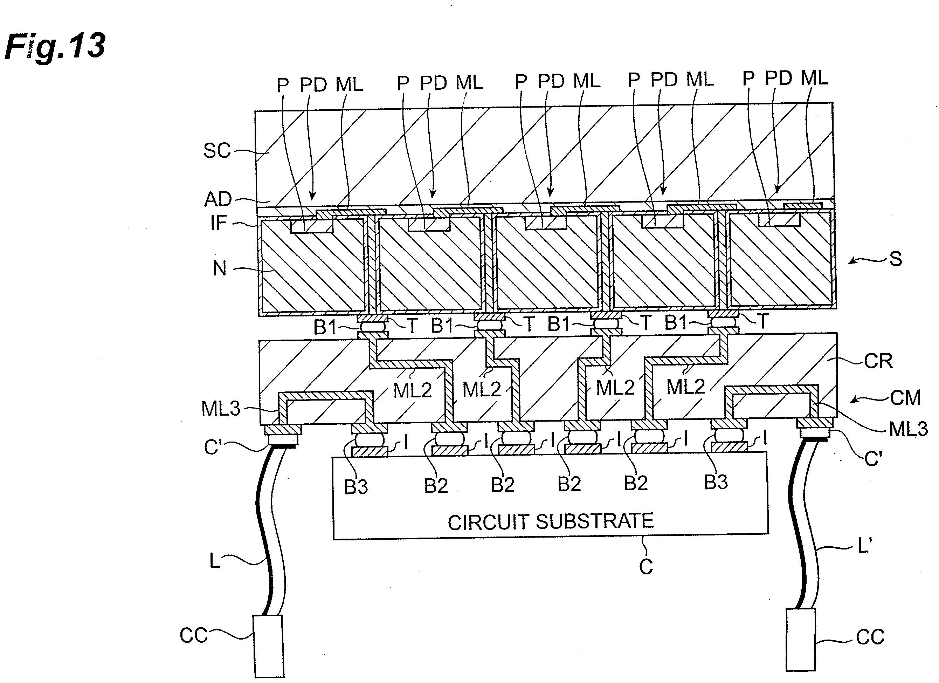

Fig. 13 is a vertical sectional view of a detector D being a preferred example of the detector D shown in Fig. 1. This photodetector D is only partially different from that illustrated in Fig. 5. That is, this detector D do not have the depression DP in the connecting means CM. According to the present embodiment, the connecting means CM can be made at low price because it does not need to form the depression DP. Further, the connection defects of the bumps B2, B3 are decreased.

In this embodiment, an example that the film wiring (flexible wiring substrate) is used as the external lead L, L', is shown. The film wiring is made by forming electrical wiring on or inside an organic film such as polyimide, the film wiring has exposed wiring electrodes at the connecting means CM side, and is connected to the terminal of the metal wiring ML3 of the connecting means CM by the conductive member C'. The conductive member C' is made of solder, a material used as bump, anisotropic conductive film(ACF), anisotropic conductive paste (ACP), NCP (nonconductive paste), or the like. These materials can be combined when used. The other side of the film wiring as the external lead L, L' has an electric connector CC for connecting the wiring to an external device. When using the film wiring as the external lead L, L', the flexibility of the connection with the external device is increased. Besides the above materials, the external lead L, L' can be made of soldered metal pins or metal balls, TAB tape, or the like.

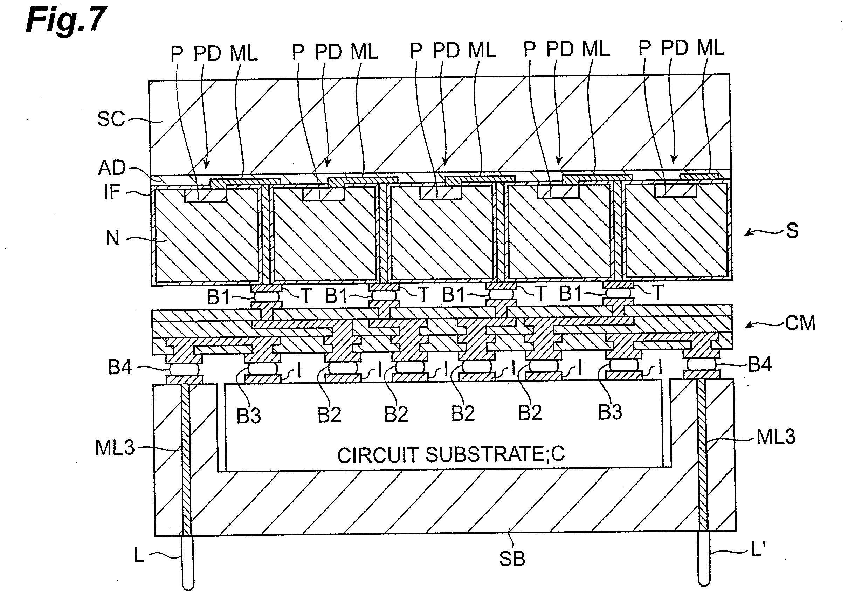

Fig. 7 is a vertical sectional view of a detector D forming a further preferred example of a detector D as illustrated in Fig. 1. This photodetector D is only partially different from that illustrated in Fig. 5.

More specifically, the connecting means CM is made from a multi-layer wiring substrate, and the output terminals T of the semiconductor chip S and the terminals on one surface of the multi-layer wiring substrate CM are connected by means of bumps B1, while the terminals on the other surface of the multi-layer wiring substrate CM and the input terminals I of the circuit substrate C are connected via bumps B2.

Moreover, the circuit substrate C is accommodated inside a supporting substrate SB having a depression, and the supporting substrate SB forms a package, bumps B4 provided on the end face of the opening in the substrate being connected via bumps B3 and the multi-layer substrate CM to the circuit substrate C, and the output of the circuit substrate C being read out successively via the bumps B4, and metal wires ML3 formed inside the supporting substrate SB which is made from ceramic base member, to the external leads L. Furthermore, input from external leads L' is transmitted via the metal wires ML3, bumps B4, multi-layer substrate CM and bumps B4 to the circuit substrate C.

The remaining composition thereof is the same as that illustrated in Fig. 5.

In the case of the structure in this example, since the semiconductor chip S, multi-layer substrate CM and circuit substrate C can be formed independently, it is possible to increase the production yield, and furthermore, a merit is obtained is that the overall thickness can be reduced by using a thin multi-layer substrate CM, compared to a ceramic base member.

Here, the circuit substrate C and the supporting substrate SB are mutually contacting. In this case, since the heat generated in the circuit substrate C is transmitted directly to the supporting substrate SB, it is possible to increase the cooling efficiency of the circuit substrate C, provided that a heat radiating material (a metal or copper alloy (CuBe, CuW) heat sink) is used for the supporting substrate SB, therefore, faulty operation of the circuit and noise can be suppressed.

Moreover, if the circuit substrate C and the supporting substrate SB are contacting each other, then in fabricating the element, after the circuit substrate C has been installed on the supporting substrate SB, it is possible to install the connecting means CM on the circuit substrate C by means of the bumps B2, B3, B4, and it is also possible to install the semiconductor chip S on the connecting means CM by means of the bumps B1. In other words, there are two installation tasks involving bumps.

Moreover, it is also possible to separate the circuit substrate C from the supporting substrate SB. In this case, one face of the connecting means CM is installed on the circuit substrate C via bumps B2, B3, whereupon the semiconductor chip S is installed on the other face of the connecting means CM via bumps B1. Thereupon, one side of the connecting means CM is installed on the supporting substrate SB via bumps B4. In this case, since the circuit substrate C is in a free floating state, it is not necessary to adjust the height of the depression of the supporting substrate SB and the circuit substrate C.

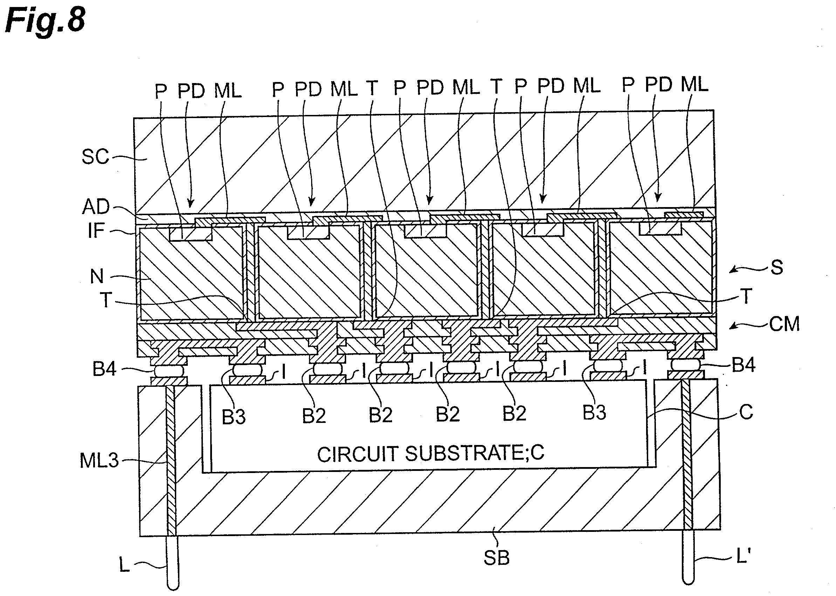

Fig. 8 is a vertical sectional view of a detector D which is a further preferred example of a detector D illustrated in Fig. 1. This detector D is only partially different from that illustrated in Fig. 7. In other words, the connecting means CM consists of a thin-film multi-layer wire formed on the back surface of a semiconductor chip S, and the terminals on the thin-film multi-layer wire CM and input terminals I of the circuit substrate C are connected by means of bumps B2.

The remaining composition is the same as that shown in Fig. 7.

Since the thin-film multi-layer wire has an extremely small thickness (2 mm, or less), it is possible dramatically to reduce the overall thickness. The output terminals T of the semiconductor chip S in this example are disposed at the boundary between the thin-film multi-layer wire CM and the semiconductor chip S, and as described above, the interval between the input terminals I is set to a narrower dimension than the interval between the output terminals T.

In the present example, the circuit substrate C and the supporting substrate SB are mutually contacting. In this case, since the heat generated by the circuit substrate C is transmitted directly to the supporting substrate SB, it is possible to increase the cooling efficiency of the circuit substrate C, provided that a heat radiating material (a metal or copper alloy (CuBe, CuW) heat sink) is used for the supporting substrate SB, therefore, faulty operation of the circuit and noise can be suppressed.

Furthermore, if the circuit substrate C and supporting substrate SB are caused to be mutually in contact, then during fabrication of the element, after installing the circuit substrate C on the supporting substrate SB, it is possible to connect the semiconductor chip S electrically to the circuit substrate C, simply by installing the connecting means CM on the circuit substrate C via the bumps B2, B3, B4. In other words, there is one installation operation involving bumps.

Furthermore, it is also possible to separate the circuit substrate C and the supporting substrate SB. In this case, one surface of the connecting means CM is installed on the circuit substrate C via the bumps B2, B3, whereupon the one surface of the connecting means CM is installed on the supporting substrate SB by means of bumps B4. In this case, since the circuit substrate C is in a free floating state, it is not necessary to adjust the height of the depression of the supporting substrate SB and the circuit substrate C.

As described above, according to the aforementioned respective detectors D, it is possible to form an signal processing circuit A on the region to the outside of the region R_{I} where the input terminals are formed on the circuit substrate C, and hence the dimensions of the circuit substrate C can be made smaller than those of the semiconductor chip S, which means that when a plurality of detectors D are aligned, the respective semiconductor chips can be disposed in mutually proximate configuration or mutually contacting configuration. Therefore, the dead area becomes small because the gap between pixel groups are extremely small, one of the pixel groups being positioned at outermost periphery of one semiconductor chip S and the other of the pixel groups being positioned at outermost periphery of the other semiconductor chip S. So, it is possible to pickup large images.

The aforementioned connecting means CM may also use, in addition to the ceramic base material, a glass, organic material as polyimide or epoxy, or a compound material of these. Moreover, desirably, the bumps B2, B3 or B4 have a different melting point to the bumps B1 connecting to the semiconductor chip S. For the material of the bumps, it is possible to use Au that can be made of a wire, Ni that can be plated, a stack of Ni and Au, solder or a resin including conductive filler. The melting point of solder can be controlled by adjusting the kind of metal materials and their composition. For example, PbSn solder system, AgSn solder system or AuSn solder system is typical, and the melting points of these materials can be adjusted by varying their composition or by adding Cu, Ag, Bi or In. Therefore, the solder material which is suitable for mounting can be chosen, and the solder material may be a eutectic alloy but is not be limited to the eutectic alloy. Moreover, desirably, the melting points of the bumps B1, bumps B2, bumps B3, and bumps B4 should be successively lower, in that order, and in this case, assembly is facilitated, since assembly can be performed in order from the higher melting point.

The typical mounting method with using bump is a thermo compression bonding or a flip-chip bonding using supersonic waves.

In the present embodiment, the bumps are directly attached to the semiconductor chip S, connecting means, and/or the circuit substrate. However, the connecting method is not limited to this method, and it is also possible to use a set of bumps and an anisotropic conductive film ACF, bumps and an anisotropic conductive paste ACP, bumps and nonconductive paste NCP, or the like. When using these methods, it is not necessary to use an underfill resin (not shown) filling operation (for increasing the mounting strength) after the bump connection.

Moreover, the photodetector element described above is not limited to being a front side illuminated type element, and it is also possible to use a back-side illuminated type element (photodiode array) formed into a thin sheet, having a PN junction on the connecting means side (back surface side) of the semiconductor substrate.

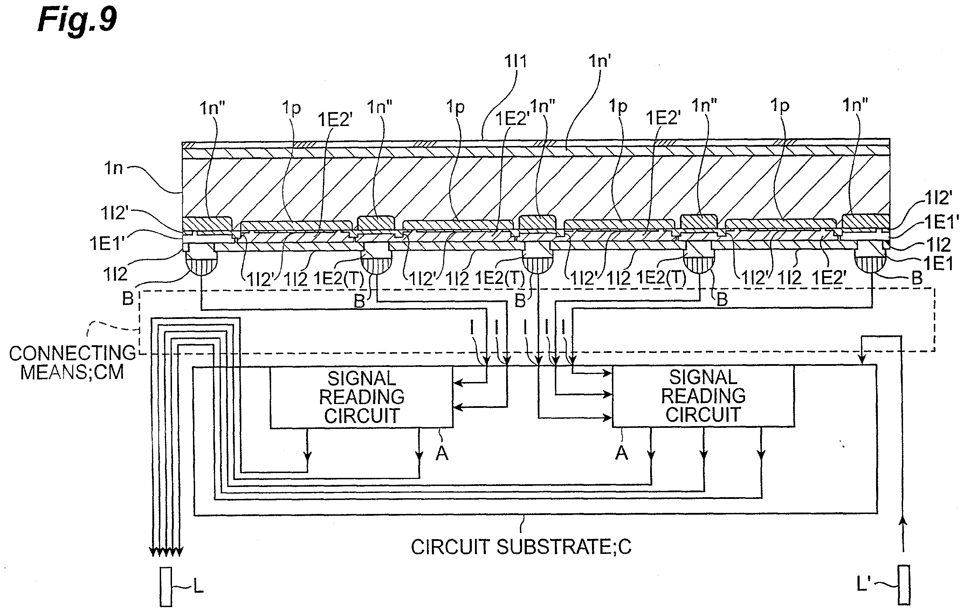

Fig. 9 shows the composition in side view of a detector D having a thin type semiconductor chip S.

This semiconductor chip S comprises output terminals T which respectively extract the outputs of a plurality of photodetector elements, these output terminals T being connected to the input terminals I of a circuit substrate C, by means of any of the connecting means CM described above.

In the detector D described in the following example, the composition other than the semiconductor chip S is the same as that in the aforementioned embodiments, and therefore only the composition of the semiconductor chip S is described below. In the detector D described in the following example, it is possible to dispose a scintillator on the plane of light incidence of the semiconductor chip S.

The semiconductor chip S according to this example comprises a high concentration impurity layer 1n' forming an accumulation layer, provided on the surface of a thin n-type semiconductor substrate 1n made from Si, on the light incident side thereof, and a plurality of p-type semiconductor regions 1p (boron-doped regions) are provided on the connecting means CM side. A pn junction (photodetector element : photodiode) is formed between the n-type semiconductor substrate 1n and each p-type semiconductor substrate 1p. The photodetector element formed by each pn junction generates electron/hole pairs (carriers) in response to the light incident on the back surface of the semiconductor chip S. A reverse bias can be applied to this pn junction of the photodetector element, if necessary. When applying the bias to the element, the depth of the depletion layer increases, and the detection sensitivity and the response speed to the light input can be increased.

The n-type separating regions 1n" are formed in the front surface region of the semiconductor substrate 1n and the wiring electrodes 1E1' for cathode electrodes form an ohmic contact with the n-type separating region 1n", the wiring electrodes 1E1' being connected to the cathode electrodes 1E1, respectively. The wiring electrodes 1E2' for anode electrodes form an ohmic contact with the p-type semiconductor region 1p, the wiring electrodes 1E2' being connected to the anode electrodes 1E2, respectively. The bump electrodes B are formed on the cathode electrodes 1E1 and the anode electrodes 1E2, and the aforementioned reverse bias is applied between the electrodes 1E1 and the electrodes 1E2 via the bump electrodes B.

Each pn junction functions as a pixel, and the n-type separating regions 1n" are formed in the region between the pixels for electrically isolating the pixels. One of the carriers generated in each pn junction (pixel) is input to each input terminal I of the circuit substrate C via the connecting means CM. The electrodes 1E2 of the semiconductor chip S are bonded to the connecting means CM via the bump electrodes B.

Note that an insulating film 1I1 is formed on the back surface of the semiconductor substrate 1n, the film 1I1 functioning as a protection film and an antireflection (AR) film. This insulating film 1I1 consists of a thermal oxide film (SiO₂), or a single layer or a film stack of SiN and/or SiON. An insulating film 1I2' is formed on the surface of the substrate 1n for protecting the surface where the dopants of the regions 1n" and 1p are diffused. An insulating film 1I2 is formed on the front side wiring electrode, the film 1I2 having openings only where the cathode electrodes 1E1 and the anode electrodes 1E2 are formed. This insulating film also consists of a thermal oxide film (SiO₂), or a single layer or a film stack of SiN, SiON or polyimide.

Moreover, the relative resistance of the semiconductor substrate 1n is approximately 50Ωcm to 10kΩcm. The depth of the high concentration impurity layer 1n' on the back side is 0.1µm to several µm and has a carrier density of at least 1 × 10¹⁷ cm⁻³ or above, formed by thermal diffusion or ion implantation of phosphorous or arsenic.

After forming the regions 1p and 1n" in the front surface region of the semiconductor substrate 1n, the back side of the substrate is thinned by polishing or etching. After that, an accumulation layer is formed at the back side of the semiconductor substrate to obtain the semiconductor chip S with thickness of for example approximately 10 to 250 µm. The preferable thickness of the semiconductor chip is approximately 50 to 100 µm. Since the semiconductor substrate of this semiconductor chip S is thin, that is, the distance between the light illuminated back side surface and the pn junction is small, the carrier traveling distance becomes short, the carrier being generated in response to the light incidence. Therefore, the present device can obtain a high sensitivity, a high speed response and a low crosstalk between the pixels.

Note that the pixel (p-type semiconductor region 1p) positioned at left side of the figure is connected to the anode electrode 1E2(T) via the wiring for the anode electrode as the other pixels (p-type semiconductor region 1p) are connected, the wiring extending perpendicular to this paper, but not depicted in the figure.

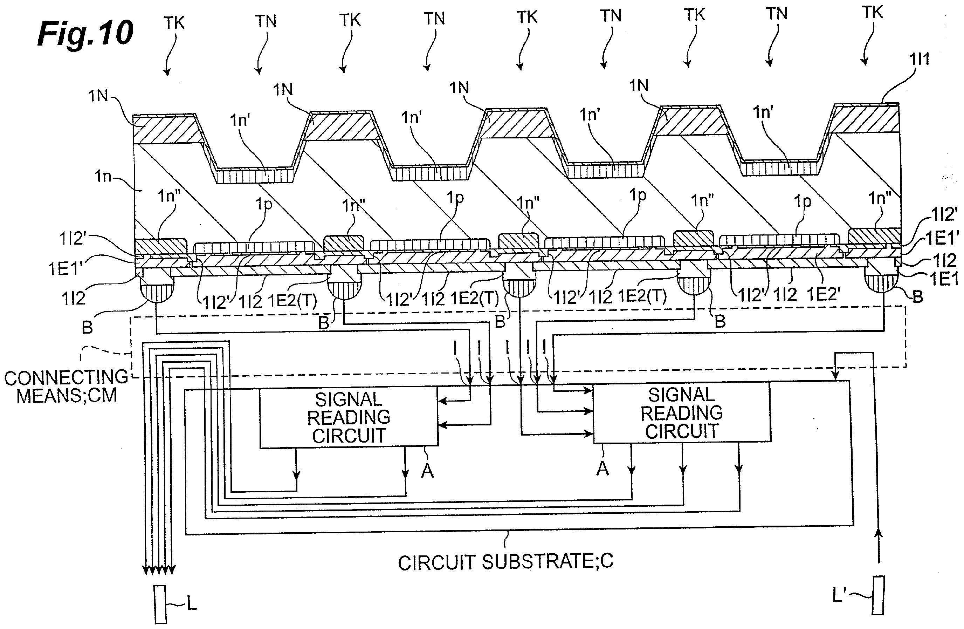

Fig. 10 shows the composition in side view of a detector provided with a semiconductor chip S having undulating sections on the side where the light is incident thereon.

In the detector D described in this example, the composition other than the semiconductor chip S is the same as that of the foregoing embodiments, and below, on the composition of the semiconductor is described. In the detector D described in the following example, a scintillator can be disposed on the light incident surface of the semiconductor chip S.

The points of differences between this semiconductor chip S and the semiconductor chip S illustrated in Fig. 9 are that (1) the maximum thickness of the semiconductor substrate In is approximately 150 to 600 µm, and the substrate has a small thickness at the photodetector element formed by pn junctions (photodiode); (2) an n-type high-density impurity region 1N is provided in the thicker regions of the back surface of the substrate; and (3) anode electrodes 1E2 (output terminals : T) are disposed on the separated regions 1n" of each photodiode via the insulating film 1I2'. Note that the arrangement of the electrodes 1E2 are not limited to on the region 1n".

The thickness of the thin portions TN of the semiconductor substrate 1n is about 50 µm - 300 µm, and the thickness of the thick portions TK thereof is about 150 - 600 µm. The thin portions TN are set to a smaller thickness than the thick portions TK. The plurality of thin portions TN, together with the plurality of thick portions TK, constitute an undulating section, and the thick portions TK are formed in a lattice configuration.

Moreover, the density of the impurity in the high concentration impurity region 1N is 1 × 10¹⁵ to 1 × 10²⁰ cm⁻³, and the depth is about 2 µm to 200 µm. The high concentration impurity layer 1n' which functions as an accumulation layer is formed over the whole of the back surface of the substrate, and the thickness thereof is 0.1 to several µm. An insulating film 1I1 is formed on the back surface of the substrate, and insulating layer 1I2' is formed on the front surface of the substrate. The wiring electrodes IE1' for the cathode electrodes and the wiring electrodes 1E2' for the anode electrodes are formed on the insulating film 1I2'. Each of the wiring electrodes IE1', IE2' passes through a contact hole formed in the insulating layer 1I2' and makes electrical contact with n-type and p-type semiconductor impurity regions In", 1p, respectively.

The anode electrode 1E2 (output terminal: T) is disposed on the separating region 1n" of each photodiode, via an insulating layer 1I2'. The anode electrode 1E2 and the separating region 1n" are set so as to correspond to a thick portion TK. The anode electrode 1E2 is pressed against the connecting means CM via a bump electrode B, but since the anode electrode 1E2 is disposed on a thick portion TK, it is possible to prevent breaking of the substrate caused by the pressing action.

An insulating film 1I2 is formed on the wiring electrodes 1E1' 1E2', and these electrodes 1E1' 1E2' are connected to the electrodes 1E1 and 1E2 through contact holes provided on an insulating film 1I2', respectively.

In this semiconductor chip S, since the semiconductor substrate 1n is thin in the thin portions TN, that is, the distance between the back illuminated surface and pn junction is small, the traveling distance of the carrier generated in response to light incidence becomes short. Therefore, the present device can obtain a high sensitivity, a high speed response and a low crosstalk between the pixels. Further, since the high concentration semiconductor regions 1N are formed in the thick portions TK, it is possible to reduce cross-talk between the pixels. The thin portions TN form a lattice shaped mask on the back surface of the substrate, and can be formed by etching the substrate using the mask.

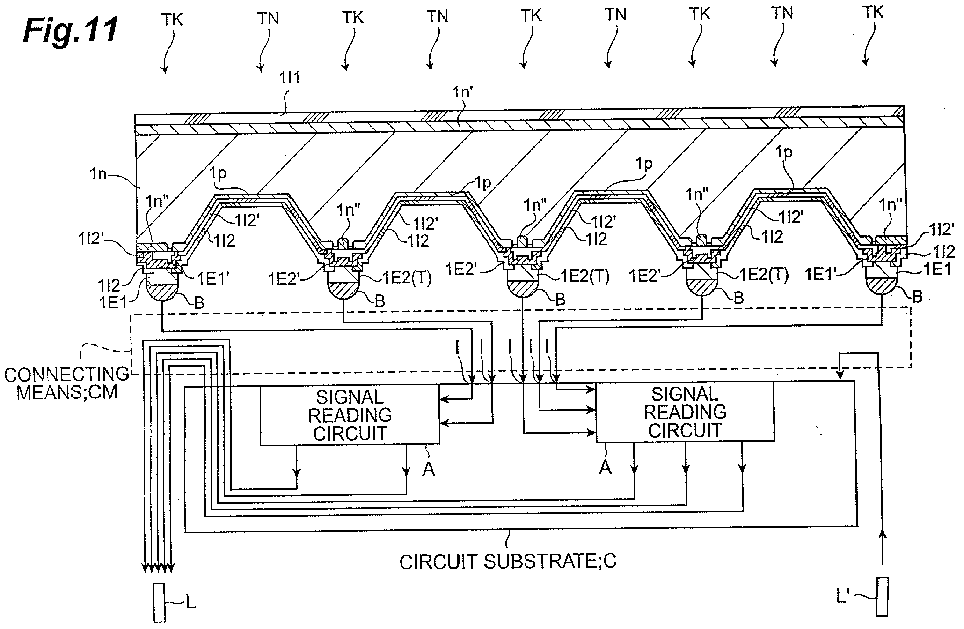

Fig. 11 shows the side composition of the detector D having a semiconductor chip S with undulating section on the circuit substrate side.

In the detector D described in this example, the composition other than the semiconductor chip S is the same as that in the foregoing embodiment, and hence only the composition of the semiconductor chip S is described below. In the detector described in the following example, a scintillator can be disposed on the light incident surface of the semiconductor chip S.

The points of difference between this semiconductor chip S and the semiconductor chip S shown in Fig. 10 are the fact that the plane of light incidence of the substrate is flat and the undulations are formed on the front surface on the connecting means CM side. In other words, p-type semiconductor regions 1p are disposed in the base region of the thin portions TN and separating regions 1n" are formed in the thick regions TK.

The thin portions TN of the present example can be formed by creating a lattice shaped mask on the substrate surface (connecting means CM side) and then performing etching using this mask. In this semiconductor chip S, since photodiodes are formed in the thin portions, the traveling distance of the carrier generated in response to light incidence becomes short, thereby the present device can obtain a high sensitivity, a high speed response and a low crosstalk between the pixels.

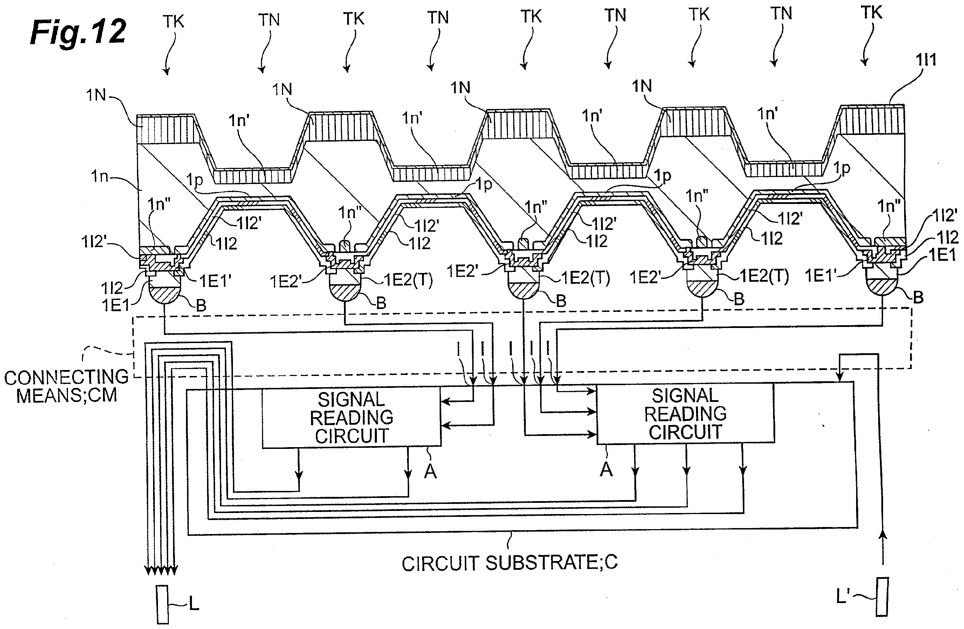

Fig. 12 shows the composition in side view of the detector D provided with a semiconductor chip S having undulating sections on the light incident side and the circuit substrate side.

In the detector D described in this example, the composition other than the semiconductor chip S is the same as that in the aforementioned embodiments, and hence only the composition of the semiconductor chip S is described below. Moreover, in the detector D described in the following example, a scintillator can be disposed on the plane of light incidence of the semiconductor chip S.

The points of difference between this semiconductor chip S and the semiconductor chip S illustrated in Fig. 11 are that the plane of light incidence face of the substrate has a undulations, as illustrated in Fig. 10, and high concentration impurity regions 1N for preventing cross-talk are formed in the thick regions TK. The thin portions TN according to this example are formed by creating a lattice-shaped mask on either face of the substrate and then using this mask to perform etching of the substrate.

The centers of the apertures of the both masks are aligned with a line extending in the thickness direction of the substrate. The depressions formed by etching are narrower at the base. Consequently, when the substrate is etched on either side thereof, a merit is obtained in that the surface area of the base portion of the depression can be increased, compared to a case where etching is performed on one side only. In this semiconductor chip S, since photodiodes are formed in the thin portions, the traveling distance of the carrier generated in response to light incidence becomes short, thereby the present device can obtain a high sensitivity, a high speed response and a low crosstalk between the pixels.

### Industrial Applicability

The present invention is applicable to a detector for use in an X-ray imaging device, or the like.

## Claims

1. A detector comprising:
a semiconductor chip (S) formed with a plurality of photodetector elements (PD) and provided with a plurality of output terminals (T) of said photodetector elements (PD) on the surface thereof;
a circuit substrate (C) provided with a plurality of input terminals (I) to which signals from said output terminals (T) are input; and
connecting means (CM) for connecting said respective output terminals (T) to said respective input terminals (I),
wherein the interval between said input terminals (I) is set to a smaller dimension than the interval between said output terminals (T);
said circuit substrate (C) comprises signal reading circuits (A) for reading out signals from said input terminals (I), wherein a region outside a region (R₁) in which said input terminals (I) are formed is surrounded by the signal readout circuits (A); and
wherein each of said photodetector elements (PD) is connected to respective output terminals (T).

2. The detector according to claim 1,
wherein said connecting means (CM) comprises a supporting substrate having metal wirings buried in a base member, said metal wirings connecting said output terminals (T) and said input terminals (I),
wherein first bumps (B1) are inserted between said output terminals (T) and said metal wirings,
wherein second bumps (B2) are inserted between said input terminals (I) and said metal wirings, and
wherein the melting point of said first bump (B1) is higher than the melting point of said second bump (B2).

3. The detector according to claim 1, wherein said connecting means (CM) also provides a connection of the outputs of said circuit substrate to external leads, and a connection from external leads to the inputs of said circuit substrate.

4. The detector according to claim 1, wherein said connecting means (CM) constitutes a supporting substrate for said semiconductor chip.

5. The detector according to claim 4, wherein said supporting substrate has a depression for accommodating said circuit substrate (C).

6. The detector according to claim 4, wherein said connecting means (CM) is formed by burying metal wiring inside a ceramic base member, said metal wiring being connected to said output terminals and said input terminals.

7. The detector according to claim 1, further comprising a scintillator (SC) formed on the light incident side of said semiconductor chip.

8. The detector according to claim 1, wherein said connecting means (CM) is constituted by a multiple-layer wiring substrate, said output terminals (T) of said semiconductor chip (S) and one surface of said multiple-layer wiring substrate being connected by means of bumps, and the other surface of said multiple-layer wiring substrate and said input terminals of said circuit substrate being connected by means of bumps.

9. The detector according to claim 1, wherein said connecting means (CM) is constituted by thin film multiple-layer wiring formed on one surface of said semiconductor chip, said thin film multiple-layer wiring and said input terminals of said circuit substrate being connected by means of bumps.

10. The detector according to claim 4, wherein the dimensions of said supporting substrate (CM) in the direction perpendicular to the thickness direction thereof are equal to or less than the dimensions of said semiconductor chip (S) in the direction perpendicular to the thickness direction thereof.

## Patentansprüche

1. Detektor, der aufweist:
einen Halbleiterchip (S), der mit einer Vielzahl von Photodetektor-Elementen (PD) ausgebildet und mit einer Vielzahl von Ausgangsanschlüssen (T) der Photodetektor-Elemente (PD) auf seiner Oberfläche versehen ist;
ein Schaltungssubstrat (C), das mit einer Vielzahl von Eingangsanschlüssen (I) versehen ist, denen Signale von den Ausgangsanschlüssen (T) zugeführt werden, und
eine Verbindungseinrichtung (CM) zum Verbinden der jeweiligen Ausgangsanschlüsse (T) mit den entsprechenden Eingangsanschlüssen (I),
wobei der Abstand zwischen den Eingangsanschlüssen (I) auf ein kleineres Maß festgesetzt ist als der Abstand zwischen den Ausgangsanschlüssen (T),
das Schaltungssubstrat (C) Signalleseschaltungen (A) zum Auslesen von Signalen von den Eingangsanschlüssen (I) aufweist, wobei ein Bereich außerhalb eines Bereichs (R₁), in dem die Eingangsanschlüsse (I) ausgebildet sind, durch die Signalleseschaltungen (A) umgeben ist, und
wobei jedes der Photodetektor-Elemente (PD) mit entsprechenden Ausgangsanschlüssen (T) verbunden ist.

2. Detektor nach Anspruch 1,
bei dem die Verbindungseinrichtung (CM) ein tragendes Substrat umfasst, das in einem Grundelement eingebettete metallische Leitungen aufweist, wobei die metallischen Leitungen die Ausgangsanschlüsse (T) und die Eingangsanschlüsse (I) verbinden,
wobei erste Bumps (B1) zwischen den Ausgangsanschlüssen (T) und den metallischen Leitungen eingefügt sind,
wobei zweite Bumps (B2)zwischen den Eingangsanschlüssen (I) und den metallischen Leitungen eingefügt sind, und
wobei der Schmelzpunkt des ersten Bumps (B1) höher ist als der Schmelzpunkt des zweiten Bumps.

3. Detektor nach Anspruch 1, bei dem die Verbindungseinrichtung (CM) ferner eine Verbindung der Ausgänge des Schaltungssubstrats mit externen Leitungen sowie eine Verbindung von externen Leitungen mit den Eingängen des Schaltungssubstrats bereitstellt.

4. Detektor nach Anspruch 1, bei dem die Verbindungseinrichtung (CM) ein tragendes Substrat für den Halbleiterchip darstellt.

5. Detektor nach Anspruch 4, bei dem das tragende Substrat eine Einsenkung zur Aufnahme des Schaltungssubstrats (C) aufweist.

6. Detektor nach Anspruch 4, bei dem die Verbindungseinrichtung (CM) durch Einbetten von metallischen Leitungen innerhalb eines keramischen Grundelements gebildet ist, wobei die metallischen Leitungen mit den Ausgangsanschlüssen und den Eingangsanschlüssen verbunden sind.

7. Detektor nach Anspruch 1, der ferner einen Szintillator (SC) aufweist, der auf der Lichteinfallsseite des Halbleiterchips ausgebildet ist.

8. Detektor nach Anspruch 1, bei dem die Verbindungseinrichtung (CM) durch ein mehrschichtiges Verdrahtungssubstrat gebildet wird, wobei die Ausgangsanschlüsse (T) des Halbleiterchips (S) und eine Fläche des mehrschichtigen Verdrahtungssubstrats durch Bumps verbunden sind und die andere Fläche des mehrschichtigen Verdrahtungssubstrats und die Eingangsanschlüsse des Schaltungssubstrats durch Bumps verbunden sind.

9. Detektor nach Anspruch 1, bei dem die Verbindungseinrichtung (CM) durch eine mehrschichtige Dünnschicht-Verdrahtung gebildet wird, die auf einer Fläche des Halbleiterchips ausgebildet ist, wobei die mehrschichtige Dünnschicht-Verdrahtung und die Eingangsanschlüsse des Schaltungssubstrats durch Bumps verbunden sind.

10. Detektor nach Anspruch 4, bei dem die Abmessungen des tragenden Substrats (CM) in der Richtung senkrecht zu seiner Dickenrichtung gleich den Abmessungen des Halbleiterchips (S) in der Richtung senkrecht zu seiner Dickenrichtung oder kleiner als die Abmessungen des Halbleiterchips (S) in der Richtung senkrecht zu seiner Dickenrichtung sind.

## Revendications

1. Détecteur comprenant :
une puce semi-conductrice (S) formée d'une pluralité d'éléments photodétecteurs (PD) et munie d'une pluralité de bornes de sortie (T) desdits éléments photodétecteurs (PD) sur la surface de ceux-ci ;
un substrat de circuit (C) muni d'une pluralité de bornes d'entrée (I) dans lesquelles des signaux provenant desdites bornes de sortie (T) sont entrés ; et
des moyens de connexion (CM) pour connecter lesdites bornes de sortie respectives (T) auxdites bornes d'entrée respectives (I),
dans lequel l'intervalle entre lesdites bornes d'entrée (I) est établi à une dimension plus petite que l'intervalle entre lesdites bornes de sortie (T) ;
ledit substrat de circuit (C) comprend des circuits de lecture de signaux (A) pour lire des signaux à partir desdites bornes d'entrée (I), dans lequel une région en dehors d'une région (R₁), dans laquelle lesdites bornes d'entrée (I) sont formées, est entourée par les circuits de lecture le signaux (A) ; et
dans lequel chacun desdits éléments photodétecteurs (PD) est connecté à des bornes de sortie respectives (T).

2. Détecteur selon la revendication 1,
dans lequel lesdits moyens de connexion (CM) comprennent un substrat de support ayant des câblages métalliques enterrés dans un élément de base, lesdits câblages métalliques reliant lesdites bornes de sortie (T) et lesdites bornes d'entrée (I),
dans lequel des premières bosses (B1) sont insérées entre lesdites bornes de sortie (T) et lesdits câblages métalliques,
dans lequel des secondes bosses (B2) sont insérées entre lesdites bornes d'entrée (I) et lesdits câblages métalliques, et
dans lequel le point de fusion de ladite première bosse (B1) est plus élevé que le point de fusion de ladite seconde bosse (B2).

3. Détecteur selon la revendication 1, dans lequel lesdits moyens de connexion (CM) fournissent également une connexion des sorties dudit substrat de circuit à des conducteurs externes, et une connexion des conducteurs externes aux entrées dudit substrat de circuit.

4. Détecteur selon la revendication 1, dans lequel lesdits moyens de connexion (CM) constituent un substrat de support pour ladite puce semi-conductrice.

5. Détecteur selon la revendication 4, dans lequel ledit substrat de support a une dépression pour recevoir ledit substrat de circuit (C).

6. Détecteur selon la revendication 4, dans lequel lesdits moyens de connexion (CM) sont formés en enterrant un câblage métallique à l'intérieur d'un élément de base en céramique, ledit câblage métallique étant connecté auxdites bornes de sortie et auxdites bornes d'entrée.

7. Détecteur selon la revendication 1, comprenant en outre un scintillateur (SC) formé sur le côté d'incidence de lumière de ladite puce semi-conductrice.

8. Détecteur selon la revendication 1, dans lequel lesdits moyens de connexion (CM) sont constitués d'un substrat de câblage multicouche, lesdites bornes de sortie (T) de ladite puce semi-conductrice (S) et une surface dudit substrat de câblage multicouche étant connectées par l'intermédiaire de bosses, et l'autre surface dudit substrat de câblage multicouche et lesdites bornes d'entrée dudit substrat de circuit étant connectées par l'intermédiaire de bosses.

9. Détecteur selon la revendication 1, dans lequel lesdits moyens de connexion (CM) sont constitués d'un câblage multicouche à films minces formé sur une surface de ladite puce semi-conductrice, ledit câblage multicouche à films minces et lesdites bornes d'entrée dudit substrat de circuit étant connectés par l'intermédiaire de bosses.

10. Détecteur selon la revendication 4, dans lequel les dimensions dudit substrat de support (CM) dans la direction perpendiculaire à sa direction d'épaisseur sont égales ou inférieures aux dimensions de ladite puce semi-conductrice (S) dans la direction perpendiculaire à sa direction d'épaisseur.
